# FASCICULE DE BREVET EUROPEEN

(11) **EP 1 226 610 B1**
(45) Date de publication et mention de la délivrance du brevet: **12.04.2006**
(21) Numéro de dépôt: 00974603.3
(22) Date de dépôt: 30.10.2000
(51) Int. Cl.: H01L 31/0203, H01L 25/16

(54) **BOITIER SEMI-CONDUCTEUR OPTIQUE ET PROCEDE DE FABRICATION D'UN TEL BOITIER**
GEHÄUSE FÜR OPTISCHE HALBLEITERELEMENTE UND HERSTELLUNGSVERFAHREN SOLCHER GEHÄUSE
OPTICAL SEMICONDUCTOR HOUSING AND METHOD FOR MAKING SAME

(30) Priorité: 04.11.1999 FR 9913779
(43) Date de publication de la demande: 31.07.2002
(73) Titulaire: STMicroelectronics S.A., 92120 Montrouge (FR)
(72) Inventeur: VITTU, Julien, F-38000 Grenoble (FR); BRECHIGNAC, Rémi, F-38000 Grenoble (FR)
(74) Mandataire: Casalonga, Axel
(86) Numéro de dépôt international: PCT/FR2000/003022
(87) Numéro de publication internationale: WO 2001/033637

(56) Documents cités:
- EP-A- 0 790 652
- EP-A- 0 807 976
- PATENT ABSTRACTS OF JAPAN vol. 013, no. 232 (E-765), 29 mai 1989 (1989-05-29) & JP 01 039048 A (HITACHI LTD;OTHERS: 01), 9 février 1989 (1989-02-09)

## Description

La présente invention concerne un boîtier semi-conducteur optique et un procédé de fabrication d'un tel boîtier.
Un procédé de fabrication comprenant des réalisations différentes des boîtiers semi-conducteurs optiques comportant un microprocesseur et un capteur optique est connu du document EP 0 790 652. En particulier, ce document divulgue une réalisation avec un encombrement réduit dans laquelle le capteur se trouve au-dessus du microprocesseur et dans laquelle tous les deux composants sont liés électriquement par des billes métalliques de connexion de type "flip-chip". Toutefois, un tel boîtier et son procédé de fabrication ne résoud pas le problème de fabriquer un boîtier optique avec un encombrement réduit permettant le montage du capteur sur une plaque support préfabriquée comportant un microprocesseur.

Le but de la présente invention est de proposer une structure de boîtier semi-conducteur optique comprenant plusieurs composants semi-conducteurs et un procédé de fabrication d'un tel boîtier de telle sorte que ce boîtier présente un encombrement réduit et soit susceptible d'être utilisé immédiatement pour de préférence délivrer des données d'images à partir des données d'un composant semi-conducteur à capteur optique.

Selon un objet de l'invention, le boîtier semi-conducteur optique, comprend une plaque support de connexion électrique présentant un passage traversant, un premier composant semi-conducteur tel qu'un microprocesseur placé en arrière de ladite plaque support et s'étendant en face dudit passage traversant, des billes métalliques de connexion électrique interposées entre ledit premier composant et ladite plaque support dans l'espace annulaire les séparant, des moyens d'encapsulage comprenant un matériau d'enrobage s'étendant dans ledit espace annulaire, un second composant semi-conducteur dont une face avant comprend un capteur optique et dont une face arrière est fixée sur la face avant dudit premier composant au travers dudit passage traversant de ladite plaque support, des fils métalliques de connexion électrique reliant la face avant dudit second composant et la face avant de ladite plaque support, un capot avant d'encapsulage qui recouvre à distance ledit passage traversant et lesdits fils métalliques et qui comprend au moins une partie transparente s'étendant devant ledit capteur optique, et des moyens de connexion électrique extérieure disposés sur une partie découverte de ladite plaque support.

Selon l'invention, la face arrière de ladite plaque support comprend de préférence un évidement annulaire entourant ledit passage traversant, dans lequel est engagé ledit premier composant.

Selon l'invention, le boîtier peut avantageusement comprendre au moins un composant passif monté sur ladite plaque support et connecté à cette dernière.

Selon l'invention, lesdits moyens de connexion électrique extérieure comprennent de préférence un organe de connexion monté sur ladite plaque support et connecté à cette dernière.

Selon un autre objet de l'invention, le procédé de fabrication d'un boîtier semi-conducteur optique, consiste à fixer et connecter électriquement la face avant d'un premier composant semi-conducteur tel qu'un microprocesseur en arrière d'un passage traversant d'une plaque support de connexion électrique, par l'intermédiaire des billes métalliques de connexion électrique interposées entre ledit premier composant à ladite plaque support dans l'espace annulaire les séparant, à encapsuler ledit premier composant à l'aide d'un matériau d'enrobage s'étendant au moins dans ledit espace annulaire, à fixer une face arrière d'un second composant semi-conducteur sur la face avant dudit premier composant au travers dudit passage traversant de ladite plaque support, une face avant dudit second composant comprenant un capteur optique, à relier électriquement la face avant dudit second composant et la face avant de ladite plaque support par l'intermédiaire de fils métalliques de connexion électrique, et à encapsuler ledit second composant et lesdits fils métalliques sur la face avant de ladite plaque support et comprenant au moins une partie transparente s'étendant devant ledit capteur optique.

Selon l'invention, le procédé consiste de préférence à encapsuler ledit second composant et lesdits fils métalliques dans un capot avant.

Selon l'invention, le procédé consiste de préférence à fixer et relier électriquement au moins un élément de connexion électrique extérieure sur une partie découverte de ladite plaque support.

Selon l'invention, le procédé consiste de préférence à fixer et relier électriquement au moins un composant passif sur ladite plaque support.

La présente invention sera mieux comprise à l'étude d'un boîtier semi-conducteur optique et de son procédé de fabrication, décrits à titre d'exemples non limitatifs et illustrés par le dessin sur lequel :
- la figure 1 représente une première étape de fabrication d'un boîtier selon la présente invention, en vue de côté ;
- la figure 2 représente une seconde étape de fabrication dudit boîtier ;
- la figure 3 représente une troisième étape de fabrication dudit boîtier ;
- la figure 4 représente une quatrième étape de fabrication dudit premier boîtier ;
- et la figure 5 représente une vue de dessus dudit boîtier selon la figure 4.

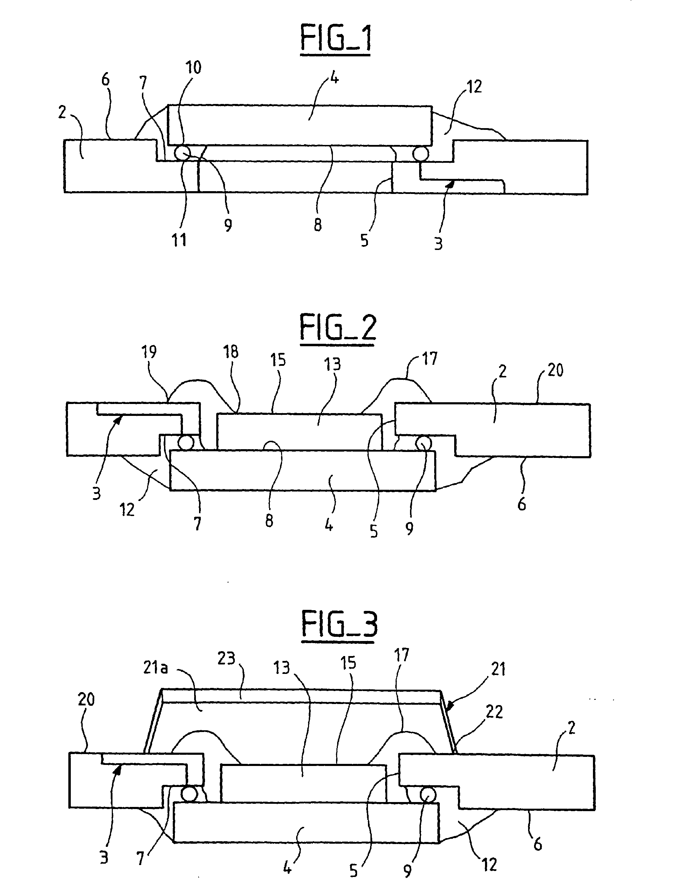

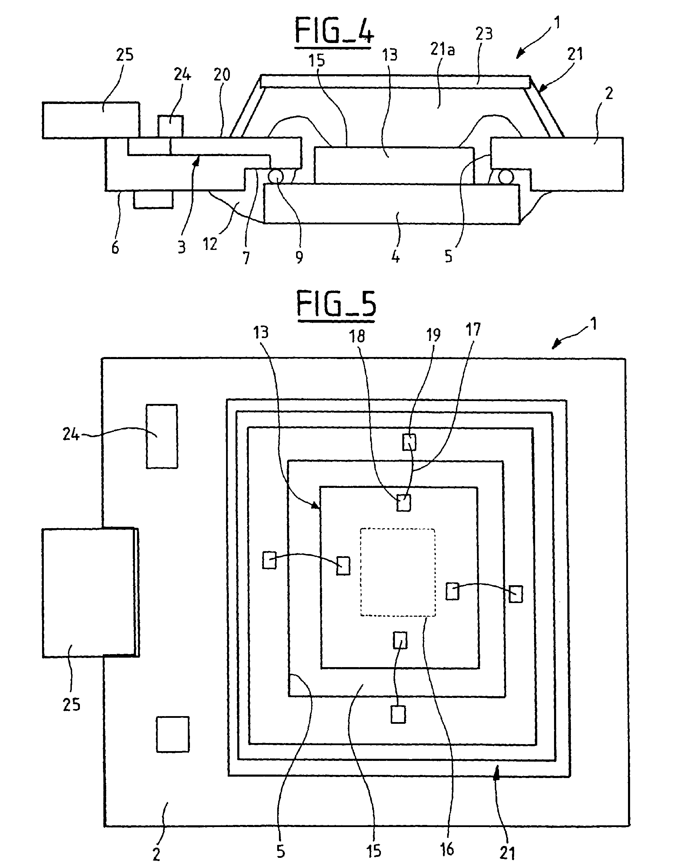

En se reportant aux figures 1 à 5, on va décrire les différentes étapes de fabrication d'un boîtier semi-conducteur optique repéré d'une manière générale par la référence 1 et représenté terminé sur les figures 4 et 5.

En référence à la figure 1, on voit qu'on dispose, de façon préfabriquée, d'un substrat 2 constitué par une plaque support qui présente des lignes internes et/ou externes constituant un réseau 3 de connexions électriques et d'un premier composant semi-conducteur 4 tel qu'un microprocesseur ou coprocesseur.

La plaque support 2 présente un passage traversant 5 et, dans sa face arrière 6, un évidement ou lamage annulaire 7 entourant le passage traversant 5.

Dans une première étape de fabrication, on fixe et on connecte électriquement la face avant 8 du composant 4 au fond de l'évidement annulaire 7 par l'intermédiaire d'une multiplicité de billes métalliques 9 réparties qui sont interposées entre d'une part des plots métalliques de connexion 10 réalisés en surface sur la face avant 8 du composant 4 et d'autre part des plots métalliques de connexion 11 réalisés en surface au fond de l'évidement 35 et reliés au réseau 3. Dans cette position assemblée, le composant 4 pénétre légèrement dans l'évidement 7.

Dans une seconde étape de fabrication également représentée sur la figure 1, on encapsule le composant 4 sur la face arrière 6 de la plaque support 2 en remplissant l'espace annulaire séparant la face avant 8 du composant 4 et la face arrière 6 de la plaque support 2 d'un matériau d'enrobage et d'étanchéité 12 dans lequel se trouvent noyées les billes métalliques de connexion 9.

Dans une troisième étape de fabrication représentée sur la figure 2, on fixe par l'intermédiaire d'une couche de colle la face arrière d'un second composant semi-conducteur 13 sur la face avant 8 du composant 4 au travers du passage traversant 5 de la plaque support 2, la face avant 15 du composant 13 présentant un capteur optique 16 dans sa partie centrale.

Puis, on relie électriquement le composant optique 13 au réseau de connexion électrique 3 de la plaque support 2 en fixant l'une des extrémités de fils de connexion électrique 17 à des plots métalliques 18 formés en surface sur la face avant 45 du composant optique 4, autour de son capteur optique 16, et en fixant l'autre extrémité des fils de connexion électrique 17 à des plots métalliques 19 du réseau 3, formés en surface sur la face avant 20 de la plaque support 2, autour de son passage traversant 5.

Dans une quatrième étape de fabrication représenté sur la figure 3, on réalise une encapsulation avant en disposant au-dessus et à distance du composant optique 13 et des fils de connexion électrique 17 un capot 21 en forme de cuvette, délimitant une cavité 21a, dont on fixe par collage le bord périphérique 22 sur la face avant 20 de la plaque support 1, à distance des plots 19. Ce capot présente un fond 23 en un matériau transparent qui s'étend parallèlement à la face avant 15 du composant optique 13.

Dans une quatrième étape de fabrication représentée sur la figure 4, on fixe des composants électroniques passifs 24, tels que des résistances et/ou des condensateurs, sur la partie découverte de la face avant 20 de la plaque support 2, latéralement au capot 21, et/ou sur la partie découverte de la face arrière 6 de la plaque support 2, latéralement au composant 4, ces composants électroniques 22 étant en même temps connectés électriquement au réseau de connexion 3 de la plaque support 2.

Puis, on fixe un organe de connexion électrique extérieure ou connecteur de branchement 25 en bout d'une partie découverte de la plaque support 2, cet organe 25 étant en même temps connecté électriquement au réseau de connexion 3 de la plaque support 2.

On obtient ainsi, comme le montrent les figures 4 et 5, un boîtier semi-conducteur optique 1 complet, équipé d'un composant semi-conducteur optique 13 et de différents composants électroniques de traitement 4 et 22, reliés électriquement de façon adaptée par l'intermédiaire du réseau de connexion électrique 3 de la plaque support 2 et susceptibles d'être connectés à un circuit extérieur grâce au connecteur électrique 25.

## Revendications

1. Boîtier semi-conducteur optique, **caractérisé par le fait qu'**il comprend :
- une plaque support de connexion électrique (2) présentant un passage traversant (5),
- un premier composant semi-conducteur (4) tel qu'un microprocesseur placé en arrière de ladite plaque support et s'étendant en face dudit passage traversant,
- des billes métalliques de connexion électrique (9) interposées entre ledit premier composant et ladite plaque support dans l'espace annulaire les séparant,
- des moyens d'encapsulage comprenant un matériau d'enrobage (12) s'étendant dans ledit espace annulaire,
- un second composant semi-conducteur (13) dont une face avant comprend un capteur optique (16) et dont une face arrière est fixée sur la face avant (8) dudit premier composant au travers dudit passage traversant (5) de ladite plaque support (2),
- des fils métalliques de connexion électrique (17) reliant la face avant dudit second composant et la face avant de ladite plaque support,
- un capot avant d'encapsulage (21) qui recouvre à distance ledit passage traversant et lesdits fils métalliques et qui comprend au moins une partie transparente s'étendant devant ledit capteur optique,
- et des moyens de connexion électrique extérieure (25) disposés sur une partie découverte de ladite plaque support (2).

2. Boîtier selon la revendication 1, **caractérisé par le fait que** la face arrière de ladite plaque support comprend un évidement annulaire (7) entourant ledit passage traversant (5), dans lequel est engagé ledit premier composant (4).

3. Boîtier selon l'une des revendications 1 et 2, **caractérisé par le fait qu'**il comprend au moins un composant passif (22) monté sur ladite plaque support (2) et connecté à cette dernière.

4. Boîtier selon l'une quelconque des revendications 1 à 3, **caractérisé par le fait que** lesdits moyens de connexion électrique extérieure comprennent un organe de connexion (25) monté sur ladite plaque support (2) et connecté à cette dernière.

5. Procédé de fabrication d'un boîtier semi-conducteur optique, **caractérisé par le fait qu'**il consiste :
- à fixer et connecter électriquement la face avant d'un premier composant semi-conducteur (4) tel qu'un microprocesseur en arrière d'un passage traversant (5) d'une plaque support de connexion électrique (2), par l'intermédiaire de billes métalliques de connexion électrique (9) interposées entre ledit premier composant à ladite plaque support dans l'espace annulaire les séparant,
- à encapsuler ledit premier composant à l'aide d'un matériau d'enrobage (12) s'étendant au moins dans ledit espace annulaire,
- à fixer une face arrière d'un second composant semi-conducteur (15) sur la face avant dudit premier composant au travers dudit passage traversant (5) de ladite plaque support (2), une face avant dudit second composant comprenant un capteur optique (16),
- à relier électriquement la face avant dudit second composant optique (13) et la face avant de ladite plaque (2) support par l'intermédiaire de fils métalliques de connexion électrique (17),
- et à encapsuler ledit second composant et lesdits fils métalliques sur la face avant de ladite plaque support, dans un capot avant (21) comprenant au moins une partie transparente s'étendant devant ledit capteur optique.

6. Procédé selon la revendication 5, **caractérisé par le fait qu'**il consiste à fixer et relier électriquement au moins un organe de connexion électrique extérieure (25) sur une partie découverte de ladite plaque support (2).

7. Procédé selon l'une quelconque des revendications 5 et 6, **caractérisé par le fait qu'**il consiste à fixer et relier électriquement au moins un composant passif (24) sur ladite plaque support (2).

## Patentansprüche

1. Gehäuse für optische Halbleiterelemente, **gekennzeichnet durch**:
- eine Trägerplatte für einen elektrischen Anschluß (2), die eine hindurchgehende Bohrung (5) aufweist,
- ein erstes Halbleiterelement (4), beispielsweise einen Mikroprozessor, das hinter der Trägerplatte angeordnet ist und sich gegenüber der hindurchgehenden Bohrung erstreckt,
- Metallkugeln für einen elektrischen Anschluß (9), die zwischen dem ersten Element und der Trägerplatte in dem sie trennenden ringförmigen Raum angeordnet sind,
- ein Verkapselungsmittel, das ein Vergußmaterial (12) aufweist, das sich in den ringförmigen Raum hinein erstreckt,
- ein zweites Halbleiterelement (13), dessen vordere Fläche einen optischen Sensor (16) aufweist und dessen hintere Fläche an der vorderen Fläche (8) des erstes Elements **durch** die hindurchgehende Bohrung (5) der Trägerplatte (2) hindurch angebracht ist,
- Metalldrähte für einen elektrischen Anschluß (17), die die vordere Fläche des zweiten Elements und die vordere Fläche der Trägerplatte verbinden,
- eine vordere Verkapselungskappe (21), die in einem Abstand die hindurchgehende Bohrung und die Metalldrähte bedeckt und die mindestens einen transparenten Teil aufweist, der sich vor dem optischen Sensor erstreckt, und
- eine Einrichtung für einen externen elektrischen Anschluß (25), die an einem freiliegenden Teil der Trägerplatte (2) angeordnet ist.

2. Gehäuse nach Anspruch 1, **dadurch gekennzeichnet, daß** die hintere Fläche der Trägerplatte eine die hindurchgehende Bohrung (5) umgebende, ringförmige Aussparung (7) aufweist, in welcher das erste Element (4) eingesetzt ist.

3. Gehäuse nach Anspruch 1 oder 2, **dadurch gekennzeichnet, daß** es mindestens ein passives Element (24) aufweist, das an der Trägerplatte angebracht und angeschlossen ist.

4. Gehäuse nach einem der Ansprüche 1 bis 3, **dadurch gekennzeichnet, daß** das Mittel für einen externen elektrischen Anschluß ein Verbindungselement (25) aufweist, das an der Trägerplatte angebracht und angeschlossen ist.

5. Verfahren zur Herstellung eines Gehäuses für optische Halbleiterelemente, **dadurch gekennzeichnet, daß** es aufweist:
- Anbringen und elektrisches Anschließen der vorderen Fläche eines ersten Halbleiterelements (4), beispielsweise eines Mikroprozessors, hinter einer hindurchgehenden Bohrung (5) einer elektrischen Anschluß- und Trägerplatte (2) über elektrisch verbindende Metallkugeln (9), die zwischen dem ersten Element und der Trägerplatte in dem sie trennenden ringförmigen Raum angeordnet sind,
- Verkapseln des ersten Elements mit Hilfe eines Vergußmaterials (12), das sich mindestens in den ringförmigen Raum hinein erstreckt,
- Befestigen einer hinteren Fläche eines zweiten Halbleiterelements (15) an der vorderen Fläche des ersten Elements durch die hindurchgehende Bohrung (5) der Trägerplatte (2) hindurch, wobei eine vordere Fläche des zweiten Elements einen optischen Sensor (16) aufweist,
- elektrisches Verbinden der vorderen Fläche des zweiten optischen Elements (13) und der vorderen Fläche der Trägerplatte (2) über elektrisch verbindende Metalldrähte (17) aus, und
- Verkapseln des zweiten Elements und der Metalldrähte an der vorderen Fläche der Trägerplatte in einer vorderen Kappe (21), die mindestens einen transparenten Teil aufweist, der sich vor dem optischen Sensor erstreckt.

6. Verfahren nach Anspruch 5, **dadurch gekennzeichnet, daß** es aufweist: Anbringen und elektrisches Anschließen mindestens eines zum externen elektrischen Anschließen vorgesehenen Elements (25) an einem freiliegenden Teil der Trägerplatte (2).

7. Verfahren nach einem der Ansprüche 5 und 6, **dadurch gekennzeichnet, daß** es aufweist: Anbringen und elektrischen Anschließen mindestens eines passiven Elements (24) an der Trägerplatte (2) .

## Claims

1. Optical semiconductor package, **characterized in that** is comprises:
- an electrical connection support plate (2) having a through-passage (5);
- a first semiconductor component (4) such as a microprocessor, placed behind the said support plate and lying opposite the said through-passage;
- electrical connection metal balls (9) inserted into the annular space separating the said first component from the said support plate;
- encapsulation means comprising an encapsulation material (12) lying in the said annular space;
- a second semiconductor component (13), a front face of which has an optical sensor (16) and a rear face of which is fixed to the front face (8) of the said first component through the said through-passage (5) of the said support plate (2);
- metal electrical connection wires (17) connecting the front face of the said second component and the front face of the said support plate;
- a front encapsulation lid (21) which covers the said through-passage and the said metal wires at some distance and which has at least one transparent part lying in front of the said optical sensor; and
- external electrical connection means (25) located on an exposed part of the said support plate (2).

2. Package according to Claim 1, **characterized in that** the rear face of the said support plate has an annular hollow (7) surrounding the said through-passage (5), in which the said first component (4) is engaged.

3. Package according to either of Claims 1 and 2, **characterized in that** it comprises at least one passive component (22), mounted on and connected to the said support plate (2).

4. Package according to any one of Claims 1 to 3, **characterized in that** the said external electrical connection means comprise a connection body (25), mounted on and connected to the said support plate (2).

5. Process for fabricating an optical semiconductor package, **characterized in that** it consists in:
- fixing and electrically connecting the front face of a first semiconductor component (4) such as a microprocessor behind a through-passage (5) of an electrical connection support plate (2), via electrical connection metal balls (9) inserted into the annular space separating the said first component from the said support plate;
- encapsulating the said first component using an encapsulation material (12) lying at least in the said annular space;
- fixing a rear face of a second semiconductor component (15) to the front face of the said first component through the said through-passage (5) of the said support plate (2), a front face of the said second component having an optical sensor (16);
- electrically connecting the front face of the said second optical component (13) and the front face of the said support plate (2) via electrical connection metal wires (17); and
- encapsulating the said second component and the said metal wires on the front face of the said support plate inside a front lid (21) and having at least one transparent part lying in front of the said optical sensor.

6. Process according to Claim 5, **characterized in that** it consists in fixing and electrically connecting at least one external electrical connection body (25) to an exposed part of the said support plate (2).

7. Process according to either of Claims 5 and 6, **characterized in that** it consists in fixing and electrically connecting at least one passive component (24) to the said support plate (2).
